# EUROPEAN PATENT APPLICATION

(11) **EP 4 745 378 A1**
(43) Date of publication of application: **20.05.2026**
(21) Application number: 25215691.4
(22) Date of filing: 13.11.2025
(51) Int. Cl.: F02C 3/22, F02C 7/224

(54) **CRYOGENICALLY COOLED THERMOELECTRIC GENERATOR**

(30) Priority: 14.11.2024 US 202418947840
(71) Applicant: RTX Corporation, Farmington, CT 06032 (US)
(72) Inventor: EVANS, Brandon M., Farmington, 06032 (US); TERWILLIGER, Neil J., Farmington, 06032 (US)
(74) Representative: Dehns

(57) **Abstract**

An aircraft propulsion system (20) includes a core engine (24) that includes a core flow path (C) through a main compressor (26) where an inlet airflow (58) is compressed and communicated to a combustor (28) to generate an exhaust gas flow (56) that is expanded through a main turbine section (30) to generate mechanical power to drive the main compressor (26) and a propulsive fan (22), a cryogenic fuel system (36) that includes a cryogenic fuel storage tank (38), a fuel flow path (62) for routing a cryogenic fuel flow (42) to the combustor (28) of the core engine (24), and a thermoelectric generator (46) that is in thermal communication with the cryogenic fuel flow (42) and a heat source (68) to generate a temperature differential (72) across the thermoelectric generator (46) utilized to generate electric power (48).

## Description

### TECHNICAL FIELD

The present disclosure relates generally to a thermoelectric generator for an aircraft propulsion system and more specifically to a thermoelectric generator where a cryogenic fuel provides a low temperature heat sink.

### BACKGROUND OF THE INVENTION

Gas turbine engines typically include a compressor where inlet air is compressed and delivered into a combustor. In the combustor, the compressed air is mixed with fuel and ignited to generate an exhaust gas flow. The exhaust flow is expanded through a turbine section to generate shaft power used to drive the compressor and a propulsive fan. Some energy in the high energy exhaust flow is recovered as it is expanded through a turbine section. However, a large amount of energy in the form of heat is simply exhausted from the turbine section to the atmosphere. A thermoelectric generator generates electric power in response to exposure to a temperature differential. The efficiency of such thermoelectric generators may not provide sufficient electric power at common engine operating temperatures to warrant use. The addition of cryogenic fuels may provide sufficient temperature differential to warrant consideration of a thermoelectric generator.

### SUMMARY OF THE INVENTION

According to one aspect of the present invention, there is provided an aircraft propulsion system including, among other possible things, a core engine that includes a core flow path through a main compressor where an inlet airflow is compressed and communicated to a combustor to generate an exhaust gas flow that is expanded through a main turbine section to generate mechanical power to drive the main compressor and a propulsive fan, a cryogenic fuel system that includes a cryogenic fuel storage tank, a fuel flow path for routing a cryogenic fuel flow to the combustor of the core engine, and a thermoelectric generator that is in thermal communication with the cryogenic fuel flow and a heat source to generate a temperature differential across the thermoelectric generator utilized to generate electric power.

Optionally, and in accordance with the above, the aircraft propulsion system further includes the heat source that includes the exhaust gas flow and the thermoelectric generator that is disposed within a flow path of the exhaust gas flow generated by the core engine.

Optionally, and in accordance with any of the above, the aircraft propulsion system further includes the thermoelectric generator that is disposed outside of an exhaust gas flow path.

Optionally, and in accordance with any of the above, the aircraft propulsion system further includes the heat source that includes a lubricant flow from the core engine.

Optionally, and in accordance with any of the above, the aircraft propulsion system further includes the heat source that includes a heated airflow from the core engine.

Optionally, and in accordance with any of the above, the aircraft propulsion system further includes the heated airflow that includes a bleed airflow that is drawn from a portion of the main compressor.

Optionally, and in accordance with any of the above, the aircraft propulsion system further includes an electric motor that is at least partially driven by electric power generated by the thermoelectric generator.

Optionally, and in accordance with any of the above, the aircraft propulsion system further includes the electric motor that is coupled to drive a shaft of the core engine.

Optionally, and in accordance with any of the above, the aircraft propulsion system further includes a bottoming cycle where heat from the core engine is utilized to heat a working fluid flow, the bottoming cycle includes a first heat exchanger where heat from the core engine is input into the working fluid, a bottoming turbine where a heated working fluid flow is expanded to generate mechanical power, and a fuel/working fluid heat exchanger where the cryogenic fuel flow is initially heated before being communicated to the thermoelectric generator.

Optionally, and in accordance with any of the above, the aircraft propulsion system further includes an output shaft that is driven by the bottoming turbine for driving an accessory component.

According to another aspect of the present invention, there is provided a gas turbine engine including, among other possible things, a core engine that includes a core flow path through a main compressor where an inlet airflow is compressed and communicated to a combustor to generate an exhaust gas flow that is expanded through a main turbine section to generate mechanical power to drive the main compressor, a cryogenic fuel system that includes a cryogenic fuel storage tank, a fuel flow path for routing a cryogenic fuel flow to the combustor of the core engine, and a thermoelectric generator where the cryogenic fuel flow and thermal energy from the exhaust gas flow are utilized to create a temperature differential across the thermoelectric generator utilized to generate electric power.

Optionally, and in accordance with any of the above, the gas turbine engine further includes the thermoelectric generator that is disposed within the core flow path.

Optionally, and in accordance with any of the above, the gas turbine engine further includes the thermoelectric generator that is disposed outside of the core flow path.

Optionally, and in accordance with any of the above, the gas turbine engine further includes the heat source that includes lubricant flow.

Optionally, and in accordance with any of the above, the gas turbine engine further includes the heated airflow that includes a bleed airflow that is drawn from a portion of the main compressor.

Optionally, and in accordance with any of the above, the gas turbine engine further includes an electric motor at least partially driven by electric power generated by the thermoelectric generator.

Optionally, and in accordance with any of the above, the gas turbine engine further includes a bottoming cycle where heat from the core engine is utilized to heat a working fluid flow, the bottoming cycle includes a working fluid that circulates within a closed circuit that includes a bottoming compressor, a bottoming turbine that is coupled to drive the bottoming compressor through a bottoming output shaft, a first heat exchanger where heat from the core engine is input into the working fluid, and a fuel/working fluid heat exchanger where the working fluid flow is in thermal communication with a portion of the cryogenic fuel flow and heated before communication to the thermoelectric generator.

According to another aspect of the present invention, there is provided a method of operating an aircraft propulsion system including, among other possible things, generating an exhaust gas flow in a combustor by igniting a mixture of compressed air and a cryogenic fuel, thermally communicating a cryogenic fuel flow with a thermoelectric generator, thermally communicating heat from a heat source with thermoelectric generator to generate a temperature differential across the thermoelectric generator between the heat and the cryogenic fuel flow, and generating electric power with the thermoelectric generator in response to the temperature differential created across the thermoelectric generator by the heat source and the cryogenic fuel flow.

Optionally, and in accordance with any of the above, the method further includes the heat source that includes heat from the exhaust gas flow.

Optionally, and in accordance with any of the above, the method further includes driving an electric motor that is coupled to an engine shaft with at least a portion of electric power generated by the thermoelectric generator.

Although the different examples have the specific components shown in the illustrations, embodiments of this disclosure are not limited to those particular combinations. It is possible to use some of the components or features from one of the examples in combination with features or components from another one of the examples.

These and other features disclosed herein can be best understood from the following specification and drawings, the following of which is a brief description.

### BRIEF DESCRIPTION OF THE DRAWINGS

Figure 1 is a schematic view of an example aircraft propulsion system.
Figure 2 is a schematic view of an example thermoelectric generator.
Figure 3 is a schematic view of another example aircraft propulsion system.
Figure 4 is a schematic view of another example aircraft propulsion system including a bottoming cycle.

### DETAILED DESCRIPTION

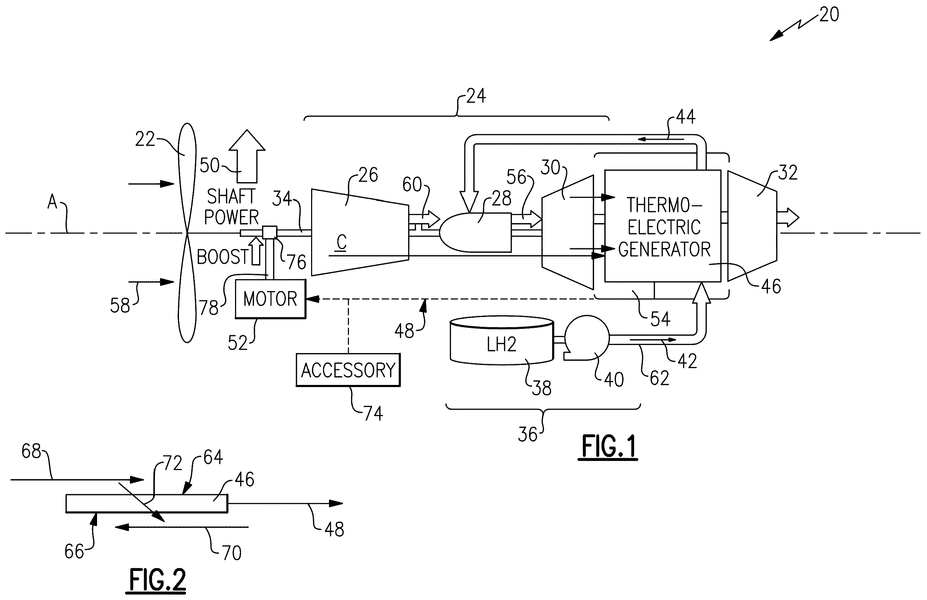

Figure 1 schematically illustrates an aircraft propulsion system 20 that includes a thermoelectric generator 46 in thermal communication with a cryogenic fuel flow 42 and a heat source to generate a temperature differential across the thermoelectric generator 46 utilized to generate electric power schematically illustrated at 48.

The example propulsion system 20 includes a core engine 24 that generates shaft power 50 utilized to drive a propulsive fan 22. The example core engine 24 includes a compressor section 26, a combustor section 28 and the turbine section 30 disposed along the longitudinal axis A. The fan 22 drives an inlet airflow 58 into the compressor section 26. The inlet airflow 58 is compressed and communicated as a pressurized core flow 60 along a core flow path C. The pressurized core flow 60 is communicated to the combustor section 28, mixed with a fuel flow 44 and ignited to generate the exhaust gas flow 56. The exhaust gas flow 56 expands through the turbine section 30 where energy is extracted and utilized to generate shaft power 50 to drive an engine shaft 34. The engine shaft 34 drives the compressor section 26 and the fan 22. The exhaust gas flow 56 is subsequently exhausted through a nozzle 32.

Although an example engine architecture is disclosed by way of example, other turbine engine architectures are within the contemplation and scope of this disclosure. Moreover, although the disclosed non-limiting embodiment depicts a turbofan turbine engine, it should be understood that the concepts described herein are not limited to use with turbofans as the teachings may be applied to other types of turbine engines (e.g., turbofan engines, turboshaft engines, etc.). Additionally, the features of this disclosure may be applied to other engine configurations utilized to generate shaft power. Moreover, although the example described embodiments disclose and show a single thermoelectric generator, multiple thermoelectric generators could be utilized and arranged to benefit from the large thermal gradients provided by the low temperatures of the cryogenic fuel flow 42.

A cryogenic fuel system 36 includes at least a cryogenic fuel storage tank 38 and a fuel pump 40 to generate a liquid fuel flow 42 along a fuel flow path 62 to the combustor 28. The example fuel system 48 is configured to provide a hydrogen based fuel such as a liquid hydrogen (LH₂). Although hydrogen is disclosed by way of example, other cryogenic, non-carbon based fuels could be utilized and are within the contemplation of this disclosure.

The fuel in the tank 38 includes features for storing a cryogenic fuel at temperatures and/or pressures required to maintain the fuel in a liquid phase. Temperatures required to maintain the cryogenic fuel in a liquid phase may be as low as about -246 °C (-412 °F). In one example embodiment, the cryogenic fuel is maintained at a temperature below -18 °C (0 °F). In another example embodiment, the fuel is maintained in the tank 38 at temperatures below -73 °C (-100 °F). The cryogenic fuel may be maintained at temperatures below about -101 °C (-150 °F) and as low as about -259 °C (-435 °F).

The low temperature cryogenic fuel flow 42 is used in conjunction with a source of thermal energy, such as the high temperature exhaust gas flow 56 to create a temperature differential across the thermoelectric generator 46. The thermoelectric generator 46 generates electric power 48 in proportion to the temperature differential. In one example embodiment, the thermoelectric generator 46 is a solid state device that converts thermal energy directly into electric power. Electric power is generated in the thermoelectric generator 46 by a thermal gradient across conducting material that creates a heat flow from hot to cold surfaces.

Referring to Figure 2 with continued reference to Figure 1, the example thermoelectric generator 46 is a solid state device that includes a hot side 64 exposed to a source of heat indicated by arrow 68 and a cold side 66 exposed to a cold sink indicated by arrow 70. The term solid state as used in this disclosure indicates that no moving parts are used for at least portions of the thermoelectric generator. The difference in temperature between the hot side 64 and the cold side 66 creates a heat flow or temperature gradient as indicated by arrow 72.

Thermoelectric generators are formed from a material that have both high electrical conductivity and low thermal conductivity. Low thermal conductivity provides for the hot side 64 and the cold side 66 to remain hot and cold respectively to maintain the temperature gradient therebetween. Materials that are utilized for a thermoelectric generator may include bismuth telluride, lead telluride, and silicon germanium among other possible materials and compounds. The listed materials are disclosed by way of example and other materials may be used for the thermoelectric generator and are within the contemplation and scope of this disclosure.

The efficiency of the thermoelectric generator 46 is based on a ratio between the cold temperature (Tc) on the cold side 66 and the hot temperature (TH) on the hot side 64. A measure of efficiency may be measured as a Carnot Efficiency according to relationship 1-(Tc/Th), where the temperature is measured in Rankin. As appreciated, the lower the cold temperature, the greater potential efficiency for the generation of electric power across the thermoelectric generator 46.

In the example propulsion system shown in Figure 1, the thermoelectric generator 46 is in thermal communication with the exhaust gas flow 56 on the hot side 64 and the cryogenic fuel flow 42 on the cold side 66. The exhaust gas flow 56 may be of a temperature of ranging between about 700 °C and 1000 °C (1751 °R and 2291 °R). The cryogenic fuel flow 42 communicated directly from the fuel storage tank 38 may range between about -100 °C and -259 °C (312 °R and 25° R). The large difference in temperature provides for the potential of creating electric power at high efficiencies.

In the example embodiment shown in Figure 1, the thermoelectric generator 46 is disposed in thermal communication with heat within a gas flow path 54 between the turbine section 30 and the nozzle 32. The thermoelectric generator 46 is directly exposed to the temperatures of the exhaust gas flow 56 on the hot side 64. The cold side 66 is exposed to the low temperatures of the cryogenic fuel flow 42. The resulting large temperature gradient produces electric power 48.

The electric power 48 generated by the thermoelectric generator 46 is communicated to an electric motor 52. The example electric motor 52 is coupled to the engine shaft 34 to supplement power provided by the turbine section 30. A coupling 76 between the motor the motor shaft 78 and the engine shaft 34 may be through a clutch, gearbox, or any other shaft power coupling configuration. Though illustrated as coupling to the engine shaft 34 upstream of the compressor section 26, this is not intended to be so limiting, and the motor may additionally or alternatively be coupled to a shaft in the compressor section 26. Moreover, although one electric motor 52 is shown other electric motors may be included and coupled to other engine shafts to recover energy. Additionally, electric power from the thermoelectric generator 52 may be distributed among several electric motors and/or communicated to an electric bus communicating electric power to other engine and aircraft systems.

Electric power 48 may also be communicated to any other accessory as indicated at 74 associated with the propulsion system 20 or aircraft. The accessory 74 may be a battery system for storing electric energy, and/ or an electric motor for operating other engine devices such as pumps, blowers, or actuators. Additionally, the accessory item may include aircraft instruments, lighting or any other device that is powered by electric power.

Cryogenic fuel flow 42 absorbs some heat in within the thermoelectric generator 46. Accordingly, a heated fuel flow 44 from the thermoelectric generator 46 is communicated to the combustor 28. The heated fuel flow 44 may be used to as a cold sink to absorb additional thermal energy for other engine systems. The fuel flow 44 is in a gaseous form prior to being injected into the combustor section 28. Accordingly, heat from the thermoelectric generator 46 and any other heat inputs are utilized to transform the cryogenic fuel into a gas form prior injection into the combustor section 28.

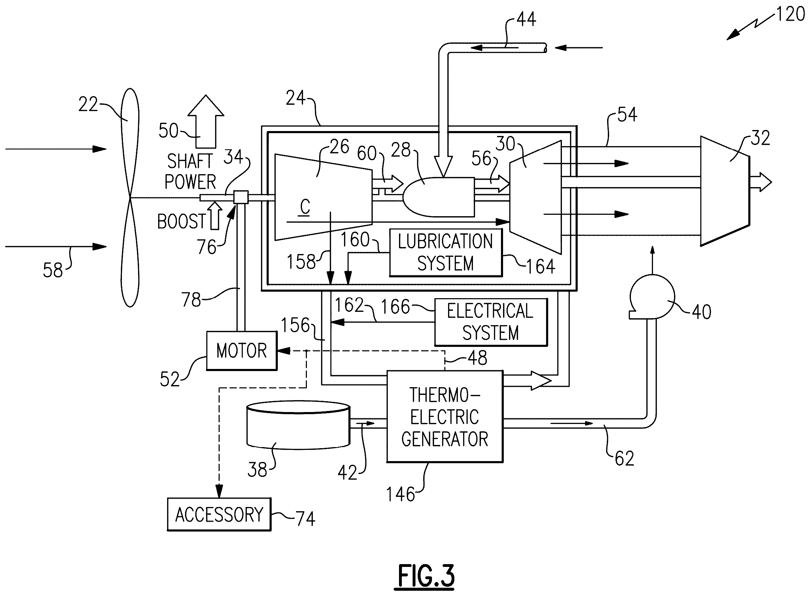

Referring to Figure 3, with continued referenced to Figure 2, another example propulsion system 120 is schematically shown and includes a thermoelectric generator 146 that is disposed outside of the flow path 54 for the exhaust gas flow 56. The thermoelectric generator 146 is in thermal communication with a heat flow 156 from the core engine 24. The heat flow 156 may originate from any other engine system that produces heat. For example, the heat flow 156 may be a lubricant flow, a working fluid flow, a heated air flow, electrical systems, and/or any other source of heat or combination of heat sources.

The example propulsion system 120 includes a lubrication system 164 that generates a lubricant flow 160. In one example embodiment, heat from the lubricant flow 160 may be communicated as the heat flow 156 to the thermoelectric generator 146.

In another example embodiment, a bleed air flow 158 from the main compressor 26 may be communicated as the heat flow 156 to the thermoelectric generator 146.

In another example embodiment, the propulsion system 120 includes an electrical system 166 that generates a heat flow 162. The heat flow 162 may be an air flow or a working fluid flow circulated to remove heat from the electrical system 166. The heat flow 162 may be communicated to thermoelectric generator 146 to induce the generation of electric power. Moreover, heat from the example heat flows may be combined to provide the heat flow 156 utilized by the thermoelectric generator 146 to produce electric power 48.

The example thermoelectric generator 146 produces electric power 48 that is communicated to the motor 52 coupled to the engine shaft 34. A coupling 76 between the motor shaft 78 and the engine shaft 34 may be through a clutch, gearbox, or any other shaft power coupling configuration. Supplemental power from the motor 52 may be provided during selected operating conditions on an intermittent basis, or constantly during engine operation.

The thermoelectric generator 146 is schematically shown and may be located anywhere within the propulsion system 120 that provides for thermal communication with both a heat source and the cryogenic fuel flow 42. Although a single thermoelectric generator 146 is disclosed and shown in the example embodiment, multiple thermoelectric generators 146 may be utilized and arranged to further produce electric power using the temperature gradient generated between a source of heat and the cryogenic fuel flow.

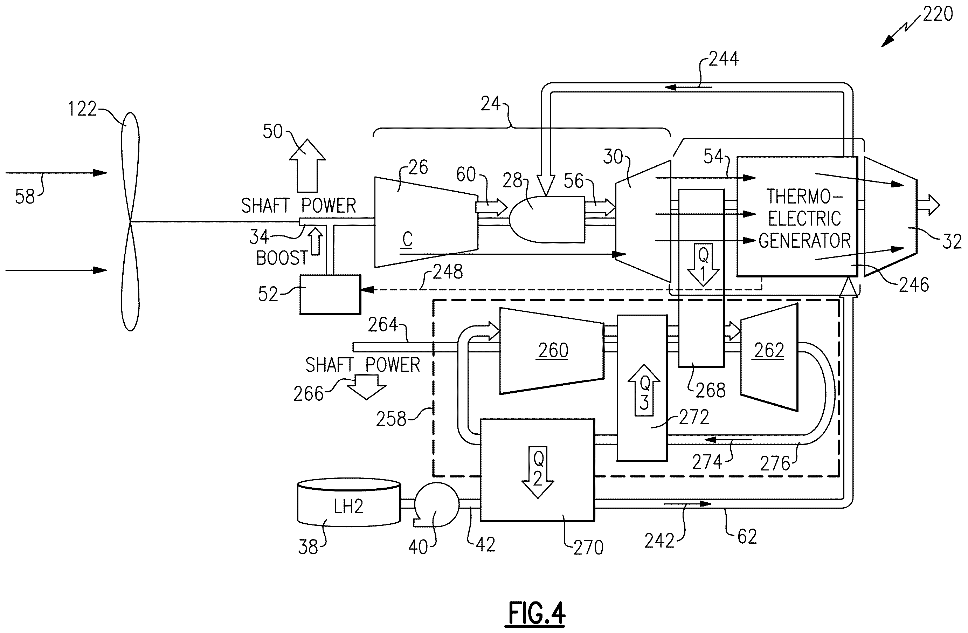

Referring to Figure 4, an example propulsion system 220 includes a bottoming cycle 258. The thermoelectric generator 246 is in thermal communication with the exhaust gas flow 56 in the exhaust gas flow path 54 between the turbine section 30 and the nozzle 32. Waste heat from the exhaust gas flow 56 is communicated to the bottoming cycle 258 to extract additional energy. The cryogenic fuel flow 42 is used both as a cold sink for the bottoming cycle 258 and for the thermoelectric generator 246.

The bottoming cycle 258 includes a working fluid 274 that flows within a closed circuit 276. The working fluid 274 is compressed in a bottoming compressor 260 and heated by the exhaust gas flow 56 through an exhaust gas/working fluid heat exchanger 268. The heated working fluid 274 is expanded through a bottoming turbine 262 to drive a bottoming shaft 264 and generate shaft power 266. The shaft power 266 may be used to drive a generator, a pump, or any other accessory device.

Working fluid 274 from the bottoming turbine 262 is cooled in a fuel/working fluid heat exchanger 270. The fuel working fluid heat exchanger 270 provides for cooling of the working fluid 274 prior to entering the bottoming compressor 260. The heat input into the cryogenic fuel flow 42 generates an initially heated fuel flow 242 that is communicated to the thermoelectric generator 246.

A working fluid heat exchanger 272 is shown and may be utilized to communicate thermal energy between different portions of the working fluid flow 274. In the disclosed example, heat from the working fluid exhausted from the bottoming turbine 262 is communicated into a pressurized working fluid flow from the bottoming compressor 260 and before heating in the exhaust/working fluid heat exchanger 268. The additional heat transferred between working fluid flow within the bottoming circuit further captures thermal energy that would otherwise be lost.

Accordingly, the disclosed propulsion systems 20, 120, and 220 utilize waste heat from the core engine in combination with the low temperatures provided by the cryogenic fuel to increase electric power generation efficiency provided by the thermoelectric generator.

Although embodiments of this disclosure have been shown, a worker of ordinary skill in this art would recognize that modifications would come within the scope of this disclosure. For that reason, the following claims should be studied to determine the true scope and content of this disclosure.

## Claims

1. An aircraft propulsion system (20) comprising:
a core engine (24) comprising a core flow path (C) through a main compressor (26) where an inlet airflow (58) is compressed and communicated to a combustor (28) to generate an exhaust gas flow (56) that is expanded through a main turbine section (30) to generate mechanical power to drive the main compressor (26) and optionally a propulsive fan (22);
a cryogenic fuel system (36) comprising a cryogenic fuel storage tank (38) and a fuel flow path (62) for routing a cryogenic fuel flow (42) to the combustor (28) of the core engine (24); and
a thermoelectric generator (46) in thermal communication with the cryogenic fuel flow (42) and a heat source (68) to generate a temperature differential (72) across the thermoelectric generator (46) utilized to generate electric power (48).

2. The aircraft propulsion system (20) as recited in claim 1, wherein the thermoelectric generator (46) is disposed within a flow path (54) of the exhaust gas flow (56) generated by the core engine (24).

3. The aircraft propulsion system (20) as recited in claim 1 or 2, wherein the heat source (68) comprises the exhaust gas flow (56).

4. The aircraft propulsion system (20) as recited in claim 1, wherein the thermoelectric generator (46) is disposed outside of an exhaust gas flow path (54).

5. The aircraft propulsion system (20) as recited in claim 1 or 4, wherein the heat source (68) comprises a lubricant flow (160) from the core engine (24).

6. The aircraft propulsion system (20) as recited in any of claims 1, 4 or 5, wherein the heat source (68) comprises a heated airflow from the core engine (24).

7. The aircraft propulsion system (20) as recited in claim 6, wherein the heated airflow, comprising a bleed airflow (158), is drawn from a portion of the main compressor (26).

8. The aircraft propulsion system (20) as recited in any preceding claim, further comprising an electric motor (52) at least partially driven by electric power (48) generated by the thermoelectric generator (46).

9. The aircraft propulsion system (20) as recited in claim 8, wherein the electric motor (52) is coupled to drive a shaft (34) of the core engine (24).

10. The aircraft propulsion system (20) as recited in any preceding claim, further comprising a bottoming cycle (258) where heat from the core engine (24) is utilized to heat a working fluid flow (274), wherein the bottoming cycle (258) comprises a first heat exchanger (268) where heat from the core engine (24) is input into the working fluid (274), a bottoming turbine (262) where a heated working fluid flow (274) is expanded to generate mechanical power (266), and a fuel/working fluid heat exchanger (270) where the cryogenic fuel flow (42) is initially heated before being communicated to the thermoelectric generator (246).

11. The aircraft propulsion system (20) as recited in claim 10, further comprising an output shaft (264) driven by the bottoming turbine (262) for driving an accessory component.

12. The aircraft propulsion system (20) as recited in claim 11, wherein the bottoming cycle (258) further comprises the working fluid (274) that circulates in a closed circuit (276) that includes a bottoming compressor (260), the bottoming turbine (262) coupled to drive the bottoming compressor (260) through the output shaft (264).

13. A method of operating an aircraft propulsion system (20) comprising:
generating an exhaust gas flow (56) in a combustor (28) by igniting a mixture of compressed air and a cryogenic fuel;
thermally communicating a cryogenic fuel flow (42) with a thermoelectric generator (46);
thermally communicating heat from a heat source (68) with thermoelectric generator (46) to generate a temperature differential (72) across the thermoelectric generator (46) between the heat and the cryogenic fuel flow (42); and
generating electric power (48) with the thermoelectric generator (46) in response to the temperature differential (72) created across the thermoelectric generator (46) by the heat source (68) and the cryogenic fuel flow (42).

14. The method as recited in claim 13, wherein the heat source (68) comprises heat from the exhaust gas flow (56).

15. The method as recited in claim 13 or 14, further comprising driving an electric motor (52) coupled to an engine shaft (34) with at least a portion of electric power (48) generated by the thermoelectric generator (46).
